# EUROPEAN PATENT APPLICATION

(11) **EP 0 867 725 A1**
(43) Date of publication of application: **30.09.1998**
(21) Application number: 98302195.7
(22) Date of filing: 24.03.1998
(51) Int. Cl.: G01R 15/20

(54) **Current sensor**

(30) Priority: 24.03.1997 JP 69760/97
(71) Applicant: Nana Electronics Co., Ltd., Machida City, Tokyo (JP)
(72) Inventor: Ishida, Toshio, Sagamihara City, Kanagawa Pref. (JP)
(74) Representative: Whalley, Kevin

(57) **Abstract**

A current sensor comprises a conductor (1) where current to be measured flows, a convex portion (1a) provided on a part of the conductor. a galvanomagnetic element (3) provided vertical with the direction of the current flowing through the convex portion under and inside thereof. and a magnetic slice (2) for fixing and integrating said conductor, convex portion, and galvanomagnetic element with each other.

## Description

The present invention relates to a current detector, more particularly a current sensor constituted by integrating it with a conductor through which current to be measured flows.

Hitherto, as a current detector to obtain a voltage output proportional to a current in the insulated state from the circuit to be measured, there is well known the current detector utilizing a current sensor or a current transformer in such a manner that a gap is provided in a part of a closed magnetic circuit (it is also called a closed magnetic path) consisting of a magnetic substance, the generated magnetic field caused by the current to be measured is converged in the gap, the output voltage proportional to current to be measured is generated by a galvanomagnetic element such as a Hall element set up in the gap, and the thus generated current is utilized for various usages.

The necessity for applying such a current sensor to the field of microelectronics has risen. That is, it is requested that the current sensor is set on the printed wiring board to detect the current to be measured detected, or the current sensor is made a chips parts.

As is known, though the Hall element being put to practical use now is very small, since the magnetic core which has the gap in the current sensing section is used, the weight reduction and the downsizing are extremely difficult as the current sensor, and it was not possible to make the current sensor to the chips parts.

An object of the present invention is to eliminate the above described defects, and to provide a highly effective current sensor which is downsized and lightened.

Another object of the present invention is to provide a current sensor having an excellent mass production, capable of mounting the sensor on a printed wiring board, and capable of making the current sensor to the chips parts.

Other object of the present invention is to provide an electronic current sensor capable of intercepting external noises caused by the change in the high-frequency voltage such as insulated gate bipolar transistors or by the change in high-frequency current.

According to an aspect of the present invention, there is provided a current sensor comprising a conductor where current to be measured flows, a convex portion provided on a part of the conductor, a galvanomagnetic element provided vertical with the direction of the current flowing through the convex portion under and inside thereof, and a magnetic slice for fixing and integrating these conductor, convex portion, and galvanomagnetic element with each other.

Moreover, gaps among the conductor, the galvanomagnetic element, and the magnetic slice are bonded and fixed by an epoxy resin etc to reinforce grasped power, and the electrical insulation properties between the conductor and the galvanomagnetic element can be strengthened.

The above galvanomagnetic element is also formed with the Hall element.

Furthermore, the galvanomagnetic element is formed with a Hall IC or a magnetoresistor.

According to another aspect of the present invention, there is provided a current sensor with an amplifier comprising a current sensor unit including a conductor where current to be measured flows, a convex portion provided on a part of the conductor, a galvanomagnetic element provided vertical with the direction of the current flowing through the convex portion under and inside thereof, and a magnetic slice for fixing and integrating these conductor, convex portion, and galvanomagnetic element with each other, a printed wiring board having an I/O terminals and an amplifier circuit and capable of mounting the current sensor unit, and a tub for the I/O terminals provided on both ends of the conductor integrally therewith for mounting the sensor on other printed circuit board.

According to the present invention, a narrow width section is provided in the middle of the conductor to be measured, and the narrow width portion is composed to become a flat convex portion, so that the distribution of magnetic field in the vicinity of the convex portion caused by the current is different from the distribution state of the magnetic field generated around other wide width conductor portion and becomes reduced partially, and thus becomes a distribution of magnetic field with high magnetic flux density.

Therefore, the magnetic flux density passing through the magnetic sensing section of the Hall element becomes high extremely compared with the magnetic flux density passing through the vicinity of the input and output terminal section of the Hall element which composes an electrical closed circuit, so that noise agitation (dφ/dt) by the induced voltage from the input and output terminal section becomes extremely small, since the voltage induced by the above input and output terminal section and caused by the change of magneticflux is remarkably small compared with the generation voltage obtained by the magnetic sensing section of the Hall element. Therefore, the current detector with excellent measuring sensitivity can be obtained.

Since the mounting on the printed wiring board is facilitated by using the conductor in a shape of flat plate having a cross-sectional area suitable for the current density used as a conductor and the conductor according to the present invention is never folded in the direction of length by providing a flat convex portion on the conductor, so that the current detector becomes a simple structure and thus can be manufactured easily and inexpensively.

Since the current density in the narrow width section provided in the center section of the conductor is higher than other wide width portions of the conductor, heat generation due to carrying electric current becomes large, but it is wide in width, so that it serves as a heat sink and the thermal diffusion becomes excellent, and thus there is no danger by which the narrow width section abnormally generates heat at all.
Fig. 1 is a perspective view showing the principle of the current sensor according to the present invention;
Fig. 2 is a side view exhibiting the current sensor according to the present invention shown in Fig. 1;
Fig. 3 is a perspective view showing the magnetic sensing section in the principle of the current sensor according to the present invention which shows on the III-III line in Fig. 1 as a cross-section;
Fig. 4 is a cross-sectional view showing a modified embodiment of the current sensor according to the present invention which shows on the IV-IV line in Fig. 1 as a cross-section;
Fig. 5 is a perspective view explaining the first embodiment of the current sensor according to the present invention; and
Fig. 6 is a perspective view explaining the second embodiment of the current sensor according to the present invention.

Now to the drawings, there are shown various embodiments of a current sensor according to the present invention. Like parts are shown by corresponding reference characters throughout several views of the drawings.

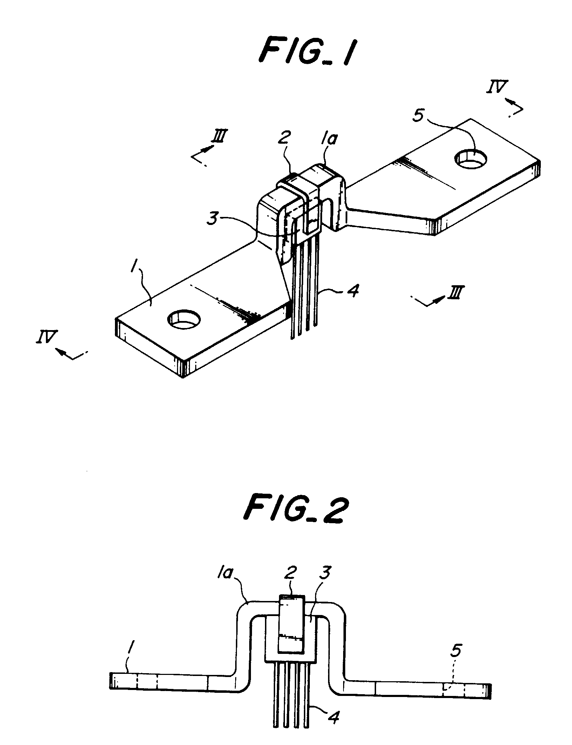

Fig. 1 shows the structure of a current sensor according to the present invention. For example, a conductor 1 to be measured, through which a current to be measured flows, is made of copper and is provided at the center portion thereof with a narrow width section la made of copper similarly as shown in Fig. 1, and this narrow width section la is composed as a flat convex portion. A galvanomagnetic element 3 such as a Hall element is arranged under and inside of the convex portion, to sandwich and reinforce the galvanomagnetic element 3 such as Hall element by a thin piece 2 of magnetic substance machined in the saddle form and to compose it with the conductor 1 to be measured integrally.

This conductor 1 is formed with the above convex portion simultaneously by the stamping process, from a flat thin plate, for example, the thin plate of almost two mm in thickness almost ten mm in width almost five cm in length.

In this case, the narrow width section has a width of 2 to 3 mm and a length of 8 to 10 mm. For example, the galvanomagnetic element 3 can be composed of the Hall element, the Hall IC or the magnetoresistor, etc, and is made small size as described above. In this embodiment, this can be protected from the external pressure by embedding it in the insulating materials such as, for example, an epoxy resin.

On the one hand, the noises are induced in the input and output terminal section 4 of the galvanomagnetic element 3 such as a Hall element according to the state of the current flowing through the conductor, so that the output current converted by the induction of the galvanomagnetic element 3 is occasionally subjected to the noise agitation. Therefore, in the present invention, the height of conductor convex portion la is defined in such a manner that the portion (so-called base portion) derived from the insulating protective member such as epoxy resins, of the I/O terminal 4 of the galvanomagnetic element 3 such as a Hall element is located from the bottom surface of conductor 1 up as shown in Fig. 2, thereby decreasing the agitation effect of the current noise, and also the influence by the external magnetic field.

In addition, in the present invention, a through-hole section 5 is provided in the vicinity of both ends of conductor 1, and the conductor 1 having the current sensing section can be fixed to other conductors by the screw-held means so that the current sensor according to the present invention can be utilized as the purposes other than utilization as chips parts, for example, as a shunt resistor, thereby making a correspondence to a current measurement.

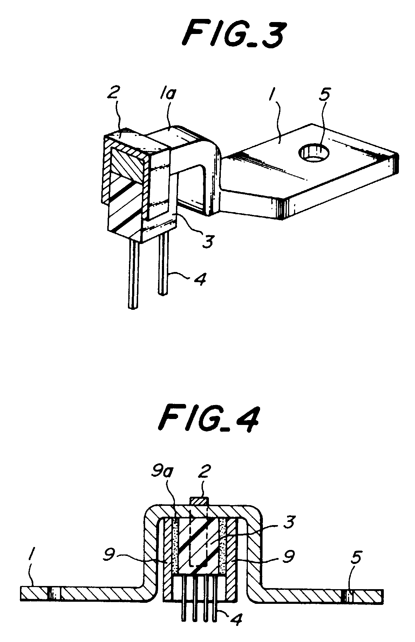

Fig. 3 is a perspective view of the current sensor according to the present invention which shows the cross-section on the III-III line in Fig. 1. In this embodiment, the space of each contact section of the conductor 1, the thin piece of magnetic substance 2, and the galvanomagnetic element 3 is cemented and fixed by an insulating material such as epoxy resin.

Fig. 4 exhibits a modified embodiment of the current sensor according to the present invention shown in Figs. 1 to 3. In this embodiment, an empty case 9 made of an insulating material such as for example plastic, having a square cross-section or a rectangular cross-section, that is, a bottom-less case, is provided, and the galvanomagnetic element 3 such as a Hall element is accommodated in the case 9, and then these case 9 and the galvanomagnetic element 3 are fixed by an insulating filler such as for example epoxy resin, and this case 9 is fixed to the lower side of the convex portion of conductor 1 by a thin piece 2 of the magnetic substance 2 in the same manner as explained in Fig. 1.

Therefore, the external pressure-tight characteristic of the galvanomagnetic element 3 can be remarkably improved. In this case, a gap is formed between outside of the case 9 and the narrow width section la of the conductor. Other portions are almost similar to the case of the current sensor explained in Fig. 1, so that its detailed explanation is omitted.

According to the current sensor in this embodiment, the noise agitation caused by the induced voltage generated at the input and output terminal section 4 by the change of magnetic flux due to the current change of the conductor ¹ becomes decreased remarkably compared with the case of the current sensor shown in Fig. 1.

In addition, the galvanomagnetic element 3 is accommodated in the case 9 to make the spaces of the inside and outside of the case 9, so that the creepage distance becomes increased, thereby improving an electrical dielectric strength.

One example of the output characteristic of the current sensor according to the present invention is shown in following table 1. As is found from this Table 1, assuming that the current flowing through the conductor 1 is If(A), and the output of the galvanomagnetic element 3 is Vh, the current sensor of 100A/34.07mV can be obtained.

**Table 1**

| | | | | | | |
|---|---|---|---|---|---|---|
| If(A) | 0 | 10 | 20 | 30 | 40 | 50 |
| Vh(mV) | 0.04 | 3.47 | 6.84 | 10.36 | 13.65 | 17.06 |
| If(A) | 60 | 70 | 80 | 90 | 100 | |
| Vh(mV) | 18.3 | 23.86 | 27.26 | 30.67 | 34.07 | |

Moreover, the dispersion between respective current sensors is in the range of 34.07 mV±8% at If = 100A, therefore, this put it to practical use enough, and thus it is confirmed that the current sensor can corresponds to a high-speed current change with the response speed at 1 µsec.

The output of the current sensor according to the present invention is a unit of mV as the data shown in the table 1, and it must be amplified by the intended electric circuit to be used, At the same time, the precision of the output voltage should be likely to be adjusted to ±1% or less by adjusting the amplification factor thereof.

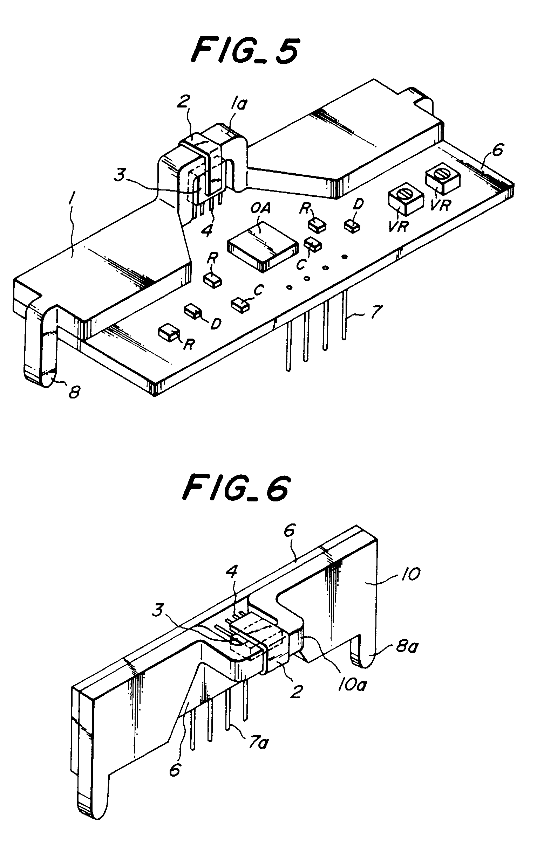

Fig. 5 shows the embodiment of the current sensor according to the present invention. In this embodiment, in accordance with the necessity of amplifying the output according to the kind of the electric circuit used as mentioned above, the current sensor combined with the amplifier circuit is provided. That is, the current sensor unit shown in Figs. 1 and 2 is arranged on and secured to a printed wiring board 6 with for example amplifier provided thereon integrally, thereby forming a current detector with the amplifier, so that the chips parts of the current sensor can be obtained.

That is, in this example, plural of terminals 7 for the power supply circuit of the amplifier and the current conversion output are provided on the printed wiring board 6. As an amplifier, commonly and well known amplifier may be used, and the various circuit elements, such as, for example, a variable resistor VR, an operational amplifier OA, a diode D, a resistor R, and a capacitor C or the like may be arranged properly as already-known. Therefore, a detailed explanation of the amplifier itself is omitted.

In addition, in this embodiment, it is possible to reload the current sensor with this amplifier on the other printed circuit boards to be sued. To this end, pin shaped tab portions 8 formed in the shape of terminal are provided on both ends of the conductor 1 flowing through the current to be measured.

In this case, terminals 7 of the printed wiring board 6 are led out downward from the printed wiring board 6. In this case, pin shaped tab portions 8 provided at both ends of the conductor 1 are projected downward in parallel to the terminal 7. In this way, if these terminals 8 and 7 are changed for the chips parts, the current detector according to the present invention can easily be made as chips parts.

In addition, in other embodiment of the current sensor according to the present invention shown in Fig. 6, a narrow width section 10a is provided to a flat conductor 10. The narrow width section 10a is made projected to the plane of conductor 10 upwardly as shown in Fig. 1 to form a convex portion, and the galvanomagnetic element 3 is arranged inside of the convex portion and is sandwiched by the thin piece of the magnetic substance 2 to form the current sensor unit.

Thus constituted current sensor unit is mounted on the printed wiring board 6. In this embodiment, tab portions 8a are provided on the both ends of the flat conductor 10 in parallel to the plane thereof, and I/O terminals 7a are provided on the printed wiring board 6 in parallel to the substrate plane, so as to be able to arrange respective terminals 7a on the same line with conductor 10. In this way, the packaging area on other printed circuit boards can be remarkably reduced.

The present invention is not limited to only the above embodiment, but various modifications and changes can be carried out within the scope of the gist of the invention.

For example, the narrow width convex portion of the above conductor is formed to the wide width conductor integrally, but only the narrow width convex portion is provided previously, and after the galvanomagnetic element is secured and fixed thereto by the magnetic slice member, both ends of the narrow width convex portion are secured to other wide width conductor portion separately provided or other conductor portions by for example the soldering and the welding or the like. In this case, securing and fixing operation for the narrow width convex portion, the galvanomagnetic element, and the magnetic slice becomes easy remarkably.

In the current sensor according to the present invention as described above, the current conductor flowing through the current to be measured and the galvanomagnetic element are formed integrally, and the magnetic core is not used for the current sensing section, so that an extremely simple parts constitution can be obtained, and thus downsizing and the miniaturization becomes easy. Therefore, the current sensor can be mounted on the printed wiring board easily, and it can be made to the chips parts as a current sensor. Also, the manufacturing cost becomes inexpensive and it is excellent in the mass production.

In addition, the current sensor according to the present invention can be applied not only to the field of microelectronics, but also to usual small sized electrical appliances.

Moreover, the magnetic flux density is high since the portion of the current carrying conductor corresponding to the magnetic sensing section is narrow in width, and thus the galvanomagnetic element can be operated effectively, so that the current with high response speed and high speed change can be detected.

In addition, the galvanomagnetic element is mounted at the inside of the flat conductor convex portion, so that the noise from the outside can be not received easily, and thus the output of the sensor can not be disturbed by the external noise.

## Claims

1. A current sensor comprising a conductor (1:10) where current to be measured flows, a convex portion (1a:10a) provided on a part of the conductor, a galvanomagnetic element (3) provided vertical with the direction of the current flowing through the convex portion under and inside thereof, and a magnetic slice (2) for fixing and integrating said conductor, convex portion, and galvanomagnetic element with each other.

2. A current sensor as claimed in claim 1, characterized in that the width of the convex portion of the said conductor is made narrower than that of other portion of the conductor.

3. A current sensor as claimed in claim 2, characterized in that the conductor and the convex portion are formed from one sheet of a plate by a stamping treatment.

4. A current sensor as claimed in claim 2, characterized in that the conductor and the convex portion are formed separately.

5. A current sensor as claimed in any of claims 1 to 4, characterized in that the galvanomagnetic element is a Hall element.

6. A current sensor as claimed in any of claims 1 to 4, characterized in that the galvanomagnetic element is a Hall IC.

7. A current sensor as claimed in any of claims 1 to 4, characterized in that the galvanomagnetic element is a magnetoresistor.

8. A current sensor with an amplifier comprising a current sensor unit including a conductor (1;10) where current to be measured flows. a convex portion (1a;10a) provided on a part of the conductor, a galvanomagnetic element (3) provided vertical with the direction of the current flowing through the convex portion under and inside thereof, and a magnetic slice (2) for fixing and integrating said conductor, convex portion, and galvanomagnetic element with each other, a printed wiring board (6) having I/O terminals (7;7a) and an amplifier circuit and capable of mounting the current sensor unit, and a tab (8;8a) for the I/O terminals provided on both ends of the conductor integrally therewith for mounting the sensor on another printed circuit board.
